# EUROPEAN PATENT APPLICATION

(11) **EP 4 648 597 A1**
(43) Date of publication of application: **12.11.2025**
(21) Application number: 24847792.9
(22) Date of filing: 11.06.2024
(51) Int. Cl.: H10K 59/88, H10K 59/80

(54) **DISPLAY SUBSTRATE AND DISPLAY DEVICE**

(30) Priority: 28.07.2023 CN 202310945297
(71) Applicant: Boe Technology Group Co., Ltd., Beijing 100015 (CN); Chongqing Boe Display Technology Co., Ltd., Chongqing 400714 (CN)
(72) Inventor: CHEN, Cheng, Beijing 100176 (CN); CUI, Jiabin, Beijing 100176 (CN); SHUAI, Fei, Beijing 100176 (CN); WANG, Qiaowen, Beijing 100176 (CN); CHEN, Aiguo, Beijing 100176 (CN); LI, Guodong, Beijing 100176 (CN)
(74) Representative: AWA Sweden AB
(86) International application number: PCT/CN2024/098514
(87) International publication number: WO 2025/025829

(57) **Abstract**

A display substrate and a display device are provided. The display substrate includes: a plurality of pixel units on a base substrate, where at least one pixel unit includes a plurality of light-emitting elements stacked along a third direction, which include a charge generation layer on the base substrate, a first light-emitting layer on a side of the charge generation layer close to the base substrate, and a second light-emitting layer on a side of the charge generation layer away from the base substrate; and at least one test component provided on the base substrate and located in the test component region, where the at least one test component includes a plurality of test elements arranged in the test component region in an array along a first direction and a second direction. The plurality of test elements include a first test element and a second test element. The first test element and the first light-emitting layer include a same material, the second test element and the second light-emitting layer include a same material, and the first test element and the second test element are arranged in two rows.

## Description

### TECHNICAL FIELD

The present disclosure relates to a field of display technology, and in particular to a display substrate and a display device.

### BACKGROUND

Organic light-emitting diode (OLED) devices have attracted much attention due to their advantages such as self-luminescence, rich colors, fast response speed, wide viewing angle, light weight, small thickness, low power consumption, and ability to achieve flexible display. A core component in an OLED product is OLED light-emitting devices, and characteristics such as light emission efficiency and lifespan of the OLED light-emitting device directly determine a core competitiveness of the product.

With the development of the OLED display technology, OLED light-emitting devices with a Tandem structure (i.e., a series structure or a stacked structure) have begun to attract the attention of researchers. In an OLED light-emitting device with a Tandem structure, a plurality of electroluminescent elements are stacked, which may improve the light emission efficiency and the lifespan of the OLED light-emitting device. How to design and manufacture an OLED display product with the Tandem structure becomes one of the important research topics for researchers.

### SUMMARY

According to an aspect of the present disclosure, a display substrate is provided, including: a base substrate, where the base substrate includes a display region and a test component region; a plurality of pixel units on the base substrate, where the plurality of pixel units are arranged in the display region in an array along a first direction and a second direction, and at least one pixel unit includes a plurality of light-emitting elements stacked along a third direction, where the plurality of light-emitting elements stacked along the third direction include a charge generation layer on the base substrate, a first light-emitting layer on a side of the charge generation layer close to the base substrate, and a second light-emitting layer on a side of the charge generation layer away from the base substrate, the first direction intersects with the second direction, and the third direction is perpendicular to each of the first direction and the second direction; and at least one test component on the base substrate, arranged in the test component region, where the at least one test component includes a plurality of test elements arranged in the test component region in an array along the first direction and the second direction. The plurality of test elements include a first test element and a second test element, the first test element and the first light-emitting layer include a same material, the second test element and the second light-emitting layer include a same material, and the first test element and the second test element are arranged in two rows. The display substrate further includes a first calibration mark on the base substrate, and the first calibration mark is arranged in the test component region and between two adjacent rows of test elements.

According to some exemplary embodiments, the first light-emitting layer includes first light-emitting sub-layers of more than one color, the at least one test component includes first test elements of more than one color, and the first light-emitting sub-layers of more than one color and the first test elements of more than one color include a same material. The second light-emitting layer includes second light-emitting sub-layers of more than one color, the at least one test component includes second test elements of more than one color, and the second light-emitting sub-layers of more than one color and the second test elements of more than one color include a same material. The test component region has a rectangular shape and has a first size in the first direction and a second size in the second direction, the first size being smaller than the second size; and a first test element and a second test element within a same test component and having a same color are arranged in two columns arranged along the first direction, and the first test element and the second test element of the same test component and having the same color are arranged in a row extending along the first direction.

According to some exemplary embodiments, first test elements within a same test component and having different colors are arranged in a same column extending along the second direction; and/or second test elements within a same test component and having different colors are arranged in a same column extending along the second direction.

According to some exemplary embodiments, the plurality of light-emitting elements stacked along the third direction further include: a first compensation layer on a side of the first light-emitting layer close to the base substrate; and a second compensation layer on a side of the second light-emitting layer close to the base substrate. The plurality of test elements further include a third test element and a fourth test element, the third test element and the first compensation layer include a same material, the fourth test element and the second compensation layer include a same material, and the third test element and the fourth test element are arranged in two rows.

According to some exemplary embodiments, the first compensation layer and the second compensation layer have a same color, and the third test element and the fourth test element are arranged in a same row extending along the first direction.

According to some exemplary embodiments, a first test element and a third test element within a same test component and having different colors are arranged in a same column extending along the second direction; and/or a second test element and a fourth test element within a same test component and having different colors are arranged in a same column extending along the second direction.

According to some exemplary embodiments, the display substrate further includes a reference mark on the base substrate, and the reference mark is located in the test component region and between two adjacent columns of test elements in the first direction.

According to some exemplary embodiments, the reference mark is located between two adjacent rows of test elements in the second direction.

According to some exemplary embodiments, the display substrate further includes a second calibration mark on the base substrate, the second calibration mark is located in the test component region and extends along the second direction, and the second calibration mark is located between two adjacent rows of test elements in the second direction.

According to some exemplary embodiments, the at least one test component includes q columns of test elements arranged along the first direction and n rows of test elements arranged along the second direction, q is a positive integer greater than or equal to 2, and n is a positive integer greater than or equal to 4.

According to some exemplary embodiments, within a same test component, a first spacing, in the first direction, between two adjacent columns of test elements arranged along the first direction is greater than or equal to 150 micrometers; and/or within the same test component, the first spacing, in the first direction, between the two adjacent columns of test elements arranged along the first direction is less than or equal to 390 microns.

According to some exemplary embodiments, the reference mark includes a first reference mark portion extending along the first direction and a second reference mark portion extending along the second direction, and the first reference mark portion and the second reference mark portion intersect at a reference point. A first imaginary line extends along the second direction and passes through the reference point, a second imaginary line extends along the second direction and passes through centers of at least two test elements in a column of test elements, a third imaginary line extends along the second direction and passes through centers of at least two test elements in another column of test elements, and a ratio of a first distance between the second imaginary line and the first imaginary line in the first direction to a second distance between the third imaginary line and the first imaginary line in the first direction ranges from 0.8 to 1.2.

According to some exemplary embodiments, a fourth imaginary line extends along the first direction and passes through the reference point, a fifth imaginary line extends along the first direction and passes through centers of test elements of a row of test elements adjacent to the reference mark, a sixth imaginary line extends along the first direction and passes through centers of test elements of another row of test elements adjacent to the reference mark, and a ratio of a third distance between the fifth imaginary line and the fourth imaginary line in the second direction to a fourth distance between the sixth imaginary line and the fourth imaginary line in the second direction ranges from 0.8 to 1.2.

According to some exemplary embodiments, the display substrate includes n first calibration marks, where in the first direction, an i^{th} first calibration mark is located between a first test element and a second test element of an i^{th} row of test elements, where 1 ≤ i ≤ n, and i is a positive integer.

According to some exemplary embodiments, the display substrate includes q second calibration marks, where in the second direction, one of the q second calibration marks is located between two first test elements in a first column of test elements.

According to some exemplary embodiments, the n rows of test elements include a k^{th} row of test elements adjacent to the reference mark and a (k+1)^{th} row of test elements adjacent to the reference mark, the k^{th} row of test elements is spaced apart from the (k+1)^{th} row of test elements in the second direction by a second spacing, where 1≤ k ≤n-1, and k is a positive integer. A p^{th} row of test elements is spaced apart from a (p+1)^{th} row of test elements in the second direction by a third spacing, where 1≤ p ≤n-1, p is a positive integer, and p is not equal to k; and the second spacing is greater than the third spacing.

According to some exemplary embodiments, the second spacing is at least twice the third spacing.

According to some exemplary embodiments, the display region of the display substrate includes a first edge, a second edge, a third edge, a fourth edge, a first corner, a second corner, a third corner and a fourth corner, and each of the first corner, the second corner, the third corner and the fourth corner is located at a respective junction of two adjacent edges among the first edge, the second edge, the third edge and the fourth edge. The display substrate includes a plurality of test components respectively arranged adjacent to the first edge, the second edge, the third edge, the fourth edge, the first corner, the second corner, the third corner and the fourth corner.

According to some exemplary embodiments, the display substrate includes a driver chip adjacent to the first edge, and at least one test component adjacent to the first edge is arranged between the driver chip and the first edge of the display region.

According to some exemplary embodiments, the display substrate includes a driver chip adjacent to the first edge, and at least one test component adjacent to the first edge is arranged on a side of the driver chip away from the first edge of the display region.

According to some exemplary embodiments, the display substrate includes two test component regions adjacent to each other, and test components in the two test component regions are arranged side by side along the first direction; and/or the display substrate includes two test component regions adjacent to each other, and test components in the two test component regions are arranged side by side along the second direction.

According to another aspect, a display device is provided, including the display substrate as described above.

### BRIEF DESCRIPTION OF THE DRAWINGS

Through the following description of embodiments of the present disclosure with reference to the accompanying drawings, the above contents and other objectives, features and advantages of the present disclosure will become clearer. In the accompanying drawings:
FIG. 1 shows a schematic top view of a display substrate according to some exemplary embodiments of the present disclosure;
FIG. 2 shows a schematic cross-sectional view of a display substrate taken along line AA' in FIG. 1 according to some exemplary embodiments of the present disclosure;
FIG. 3 shows a partial enlarged view of a test component region in the display substrate according to some exemplary embodiments of the present disclosure;
FIG. 4 schematically shows a schematic structural diagram of a mask used in an evaporation process according to some exemplary embodiments of the present disclosure;
FIG. 5 shows a schematic top view of a display substrate according to some other exemplary embodiments of the present disclosure;
FIG. 6 shows a schematic cross-sectional view of a display substrate taken along line BB' in FIG. 5 according to some other exemplary embodiments of the present disclosure;
FIG. 7 shows a partial enlarged view of a test component region in a display substrate according to some other exemplary embodiments of the present disclosure;
FIG. 8 shows a partial enlarged view of a test component region in a display substrate according to some other exemplary embodiments of the present disclosure;
FIG. 9 shows a partial enlarged view of a test component region in a display substrate according to some other exemplary embodiments of the present disclosure;
FIG. 10A and FIG. 10B respectively show partial enlarged views of a test component region in a display substrate according to yet some other exemplary embodiments of the present disclosure;
FIG. 11 shows a schematic top view of a display substrate according to yet some other exemplary embodiments of the present disclosure; and
FIG. 12 shows a schematic structural diagram of a testing apparatus for measuring a pixel position accuracy of a display substrate according to some exemplary embodiments of the present disclosure.

It will be noted that for the sake of clarity, in the accompanying drawings used to describe embodiments of the present disclosure, sizes of layers, structures or regions may be enlarged or reduced, that is, these drawings are not drawn according to actual scale.

### DETAILED DESCRIPTION OF EMBODIMENTS

In order to make objectives, technical solutions and advantages of embodiments of the present disclosure clearer, technical solutions of embodiments of the present disclosure will be clearly and completely described below with reference to the accompanying drawings. Obviously, the described embodiments are merely some embodiments rather than all embodiments of the present disclosure. Based on the described embodiments of the present disclosure, all additional embodiments obtained by those ordinary skilled in the art without carrying out inventive effort fall within the scope of protection of the present disclosure.

It will be noted that in the accompanying drawings, for the sake of clarity and/or description, sizes and relative sizes of elements may be enlarged. Accordingly, the sizes and relative sizes of the elements need not to be limited to those shown in the figures. In the specification and the accompanying drawings, the same or similar reference numerals represent the same or similar components.

Unless otherwise defined, technical or scientific terms used in the present disclosure should have the usual meanings understood by those skilled in the art. The words "first", "second" or the like used in the present disclosure do not indicate any order, quantity or importance, but are only used to distinguish different composition parts. The word "including", "containing" or the like used herein means that an element or object preceding that word covers elements or objects following that word and their equivalents, but do not exclude other elements or objects.

Herein, unless otherwise specified, directional terms such as "upper", "lower", "left", "right", "inside", "outside", etc. are used to indicate orientations or positional relationships shown based on the accompanying drawings, which is intended to facilitate the descriptions of the present disclosure and not to indicate or imply that the device, element or component referred to must have a specific orientation or must be constructed or operated in a specific orientation. It should be understood that when an absolute position of a described object changes, the relative positional relationships indicated by those terms may also change accordingly. Therefore, those directional terms may not be understood as limitations to the present disclosure.

It will be noted that the expression "the same layer" herein refers to a layer structure that is formed by firstly forming, using a same film forming process, a film layer used to form a specific pattern, and then patterning, using one-time patterning process, the film layer with a same mask. Depending on different specific patterns, the one-time patterning process may include a plurality of exposure, development or etching processes, and the specific pattern in the formed layer structure may be continuous or discontinuous. A plurality of elements, components, structures and/or portions in "the same layer" are made of the same material and formed by the same patterning process. Generally, a plurality of elements, components, structures and/or portions in "the same layer" have substantially the same thickness.

Those skilled in the art should understand that, unless otherwise specified, the expression "height" or "thickness" herein refers to a size in a direction perpendicular to a surface of each film layer provided on the display substrate, that is, a size in a light emitting direction of the display panel, or referred to as a size in a normal direction of the display device.

Herein, directional expressions "first direction" and "second direction" are used to describe different directions along pixel units, e.g., a longitudinal direction and a transverse direction of the pixel unit, or a row direction and a column direction of the arrangement of the sub-pixels. It should be understood that such expressions are merely exemplary descriptions and not limitations to the present disclosure.

In a preparation process of an OLED display device, an OLED light-emitting device may be formed using a vacuum thermal evaporation method. The vacuum thermal evaporation method, due to its moderate process complexity and a long lifespan of an OLED light-emitting device produced using it, has been used widely. In this preparation method, FMM (Fine Metal Mask) is a key part to ensure that an organic light-emitting material is accurately evaporated to a design position. The FMM includes evaporation openings corresponding to the display region. During the evaporation process, thermally evaporated organic material molecules may pass through the opening of the FMM and then be deposited to an opening of a pixel defining layer (PDL) of a backplane, thus forming a predetermined pattern.

The FMM has a fine structure, with openings of only tens of microns. Therefore, it is necessary to perform an accurate test alignment of the evaporation patterns using a TEG (Test Element Group), so as to eliminate a poor color mixing caused by a misalignment and ensure a final display effect. Evaporation patterns of each layer typically corresponds to one mask, and a Pixel Position Align TEG (PPA TEG) is provided in the mask. Through the PPA TEG, it is possible to monitor and improve the pixel position accuracy in the display screen, so as to improve a yield of display products and ensure a good display effect.

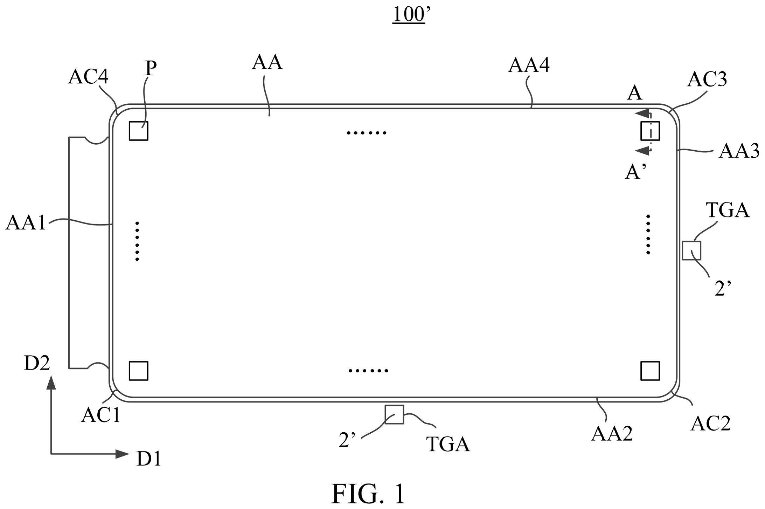

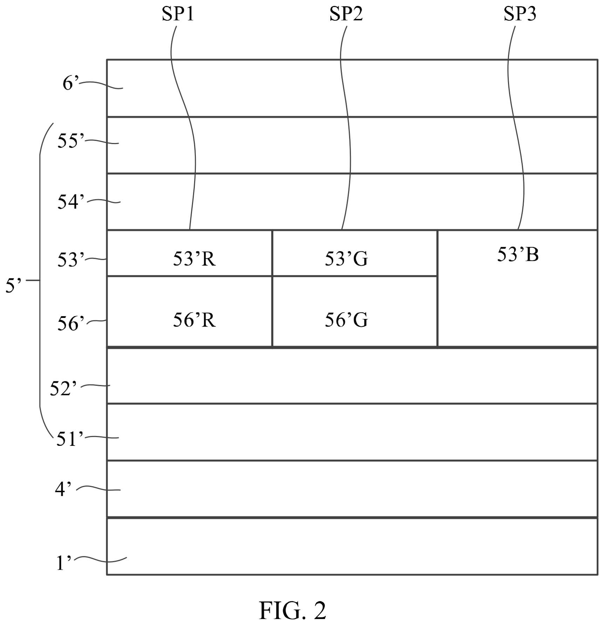

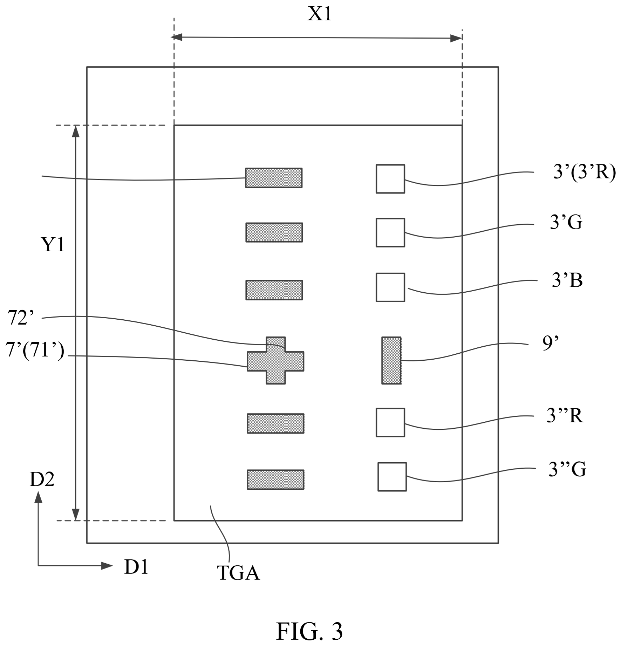

FIG. 1 shows a schematic top view of a display substrate according to some exemplary embodiments of the present disclosure, FIG. 2 shows a schematic cross-sectional view of a display substrate taken along line AA' in FIG. 1 according to some exemplary embodiments of the present disclosure, and FIG. 3 shows a partial enlarged view of a test component region in the display substrate according to some exemplary embodiments of the present disclosure.

Referring to FIG. 1 to FIG. 3 in combination, a display substrate 100' includes: a base substrate 1' including a display region AA and a test component region TGA; a plurality of pixel units P on the base substrate 1', where the plurality of pixel units P are arranged in the display region AA in an array along a first direction D1 and a second direction D2; and at least one test component 2' on the base substrate 1', where the at least one test component 2' is arranged in the test component region TGA, and the at least one test component 2' includes a plurality of test elements 3' arranged in the test component region TGA along the first direction D1 or the second direction D2.

As shown in FIG. 2, the display substrate 100' includes: in the display region AA, a first electrode 4', a second electrode 6', and a light-emitting functional layer 5' sandwiched between the first electrode 4' and the second electrode 6', which are provided on the base substrate 1. For example, the light-emitting functional layer 5' may include a hole injection layer 51', a hole transport layer 52', a light-emitting layer 53', an electron transport layer 54' and an electron injection layer 55'.

The light-emitting layer 53' may include light-emitting sub-layers of more than one color, such as a first light-emitting sub-layer 53'R, a second light-emitting sub-layer 53'G, and a third light-emitting sub-layer 53'B. The first light-emitting sub-layer 53'R, the second light-emitting sub-layer 53'G and the third light-emitting sub-layer 53'B may emit red light, green light and blue light, respectively.

In this embodiment, a pixel unit P may include at least three sub-pixels SP1, SP2 and SP3, which are a red sub-pixel, a green sub-pixel and a blue sub-pixel respectively. The sub-pixels SP1, SP2 and SP3 include the first light-emitting sub-layer 53'R, the second light-emitting sub-layer 53'G and the third light-emitting sub-layer 53'B respectively.

It will be noted that the embodiments of the present disclosure do not impose special limitations on the design of the pixel unit P. For example, it is shown in the accompanying drawings that the pixel unit P includes three sub-pixels. However, in other embodiments, a pixel unit P may include fewer or more sub-pixels. In addition, the sub-pixels in a pixel unit P may be arranged in various manners known in the art, which are not specifically limited in embodiments of the present disclosure.

With continued reference to FIG. 2, the hole injection layer 51', the hole transport layer 52', the light-emitting layer 53', the electron transport layer 54' and the electron injection layer 55' are sequentially arranged on a side of the first electrode 4' away from the base substrate 1'. In this embodiment, the first electrode 4' may be an anode, and the second electrode 6' may be a cathode. Holes provided by the first electrode 4' are transmitted to the light-emitting layer 53' with the assistance of the hole injection layer 51' and the hole transport layer 52', and electrons provided by the second electrode 6' are transmitted to the light-emitting layer 53' with the assistance of the electron injection layer 55' and the electron transport layer 54'. The holes and the electrons are recombined in the light-emitting layer 53', and the light-emitting layer 53' is excited to emit light of a corresponding color.

Optionally, the light-emitting functional layer 5' may further include an electronic blocking layer between the first electrode 4' and the light-emitting layer 53', and a hole blocking layer between the second electrode 6' and the light-emitting layer 53'.

As the red light, the green light and the blue light have different wavelengths, they may experience different losses when passing through structures above the light-emitting layer, and the larger the wavelength, the greater the loss. To ensure the same display effect across the respective pixel units P under the same conditions, in some embodiments of the present disclosure, it is possible to increase a luminance intensity of the red sub-pixel and/or the green sub-pixel, so as to compensate for the transmission loss. That is, a compensation layer may be added below the light-emitting sub-layers of the red sub-pixel and the green sub-pixel.

With continued reference to FIG. 2, the light-emitting functional layer 5' may further include a compensation layer 56'. For example, the compensation layer 56' may include a compensation sub-layer 56'R in the first sub-pixel SP1 and/or a compensation sub-layer 56'G in the second sub-pixel SP2.

The compensation sub-layer 56'R is located below the first light-emitting sub-layer 53'R. In other words, the compensation sub-layer 56'R is located between the first light-emitting sub-layer 53'R and the first electrode 4'. For example, a thickness of the compensation sub-layer 56'R is greater than that of the first light-emitting sub-layer 53'R. When the holes transported by the first electrode 4' and the electrons transported by the second electrode 6' are recombined in the compensation sub-layer 56'R, the compensation sub-layer 56'R may be excited to emit red light to enhance the intensity of the red light emitted by the first sub-pixel SP1.

The compensation sub-layer 56'G is located below the second light-emitting sub-layer 53'G. In other words, the compensation sub-layer 56'G is located between the second light-emitting sub-layer 53'G and the first electrode 4'. For example, a thickness of the compensation sub-layer 56'G is greater than that of the second light-emitting sub-layer 53'G. When the holes transported by the first electrode 4' and the electrons transported by the second electrode 6' are recombined in the compensation sub-layer 56'G, the compensation sub-layer 56'G may be excited to emit green light to enhance the intensity of the green light emitted by the second sub-pixel SP2.

Referring to FIG. 1 to FIG. 3, the display region AA of the display substrate 100' includes a first edge AA1, a second edge AA2, a third edge AA3, a fourth edge AA4, a first corner AC1, a second corner AC2, a third corner AC3 and a fourth corner AC4. Each of the first corner AC1, the second corner AC2, the third corner AC3 and the fourth corner AC4 is located at a respective junction of two adjacent edges among the first edge AA1, the second edge AA2, the third edge AA3 and the fourth edge AA4.

In some embodiments, the display substrate 100' may include a plurality of test components 2', which are arranged to be respectively adjacent to the first edge AA1, the second edge AA2, the third edge AA3, the fourth edge AA4, the first corner AC1, the second corner AC2, the third corner AC3 and the fourth corner AC4.

FIG. 3 schematically shows a partial enlarged view of a test component region. As shown in FIG. 3, at least one test component region TGA is provided with a test component 2', which may include a plurality of test elements 3'. For example, the plurality of test elements 3' may include test elements of more than one color. For ease of description, the test elements of more than one color are denoted as test elements 3'R, 3'G, 3'B, 3"R and 3"G, respectively.

The test elements 3'R, 3'G, 3'B, 3"R and 3"G of more than one color respectively correspond to the first light-emitting sub-layer 53'R, the second light-emitting sub-layer 53'G, the third light-emitting sub-layer 53'B, the compensation sub-layer 56'R and the compensation sub-layer 56'G formed using an evaporation process. Specifically, in the manufacturing process of the display substrate 100', the first light-emitting sub-layer 53'R, the second light-emitting sub-layer 53'G, the third light-emitting sub-layer 53'B, the compensation sub-layer 56'R and the compensation sub-layer 56'G are formed through multiple evaporation processes. It will be noted that the expression of "multiple evaporation processes" here means that during the multiple evaporation processes, different FMMs are employed to form the evaporated film layers, or the same FMM is employed but with different evaporation process parameters to form the evaporated film layers.

In this embodiment, the test element 3'R and the first light-emitting sub-layer 53'R are formed by the same evaporation process, the test element 3'G and the second light-emitting sub-layer 53'G are formed by the same evaporation process, the test element 3'B and the third light-emitting sub-layer 53'B are formed by the same evaporation process, the test element 3"R and the compensation sub-layer 56'R are formed by the same evaporation process, and the test element 3"G and the compensation sub-layer 56'G are formed by the same evaporation process. Accordingly, it is possible to determine the pixel position accuracy of the first light-emitting sub-layer 53'R by measuring a position accuracy of the test element 3'R, determine the pixel position accuracy of the second light-emitting sub-layer 53'G by measuring a position accuracy of the test element 3'G, determine the pixel position accuracy of the third light-emitting sub-layer 53'B by measuring the position accuracy of the test element 3'B, determine the pixel position accuracy of the compensation sub-layer 56'R by measuring a position accuracy of the test element 3"R, and determine the pixel position accuracy of the compensation sub-layer 56'G by measuring a position accuracy of the test element 3"G.

As shown in FIG. 3, a test component region TGA has a first size X1 in the first direction D1 and a second size Y1 in the second direction D2. A plurality of test elements are arranged in a column along the second direction D2 in the test component region TGA. For example, the test elements 3'R, 3'G, 3'B, 3"R and 3"G are arranged in a column along the second direction D2.

It will be noted that FIG. 3 schematically shows a shape of an orthographic projection of each test element on the base substrate 1', which is schematically shown as a square. However, the embodiments of the present disclosure are not limited to this, and the shape of the orthographic projection of each test element on the base substrate 1' may include, but is not limited to a rectangle, a circle, an ellipse, an approximately circular shape, a triangle, a rhombus, a trapezoid, a parallelogram, a pentagon, a hexagonal and other shapes.

With continued reference to FIG. 3, the display substrate 100' may further include a reference mark 7', a first calibration mark 8' and a second calibration mark 9', which are arranged on the base substrate 1'. The reference mark 7', the first calibration mark 8' and the second calibration mark 9' are all located in the test component region TGA.

The reference mark 7' may include a first reference mark portion 71' extending along the first direction D1 and a second reference mark portion 72' extending along the second direction D2, and the first reference mark portion 71' and the second reference mark portion 72' intersect at a reference point. The first calibration mark 8' extends along the first direction D1. The second calibration mark 9' extends along the second direction D2.

For example, the reference mark 7' may have a shape of a cross, and the first calibration mark 8' and the second calibration mark 9' may each have a linear shape.

In the embodiments of the present disclosure, a test component region TGA is provided with only one reference mark 7', which is used to calibrate the position of the test component region TGA.

In some embodiments, m' evaporated film layers are provided in the display region AA, where m' is a positive integer greater than or equal to 1. For example, in the shown embodiment, m' is 5, and the five evaporated film layers include the first light-emitting sub-layer 53'R, the second light-emitting sub-layer 53'G, the third light-emitting sub-layer 53'B, the compensation sub-layer 56'R and the compensation sub-layer 56'G. Accordingly, in the test component region TGA, one test component includes m' test elements, which respectively correspond to the m' evaporated film layers and are used to respectively measure the pixel position accuracy of the m' evaporated film layers.

The test component region TGA is further provided with m' first calibration marks 8', which respectively correspond to the m' test elements and are used to respectively measure the position accuracy of the m' test elements in the second direction D2.

The number of the second calibration marks 9' in the test component region TGA is consistent with the number of columns of the m' test elements. For example, in this embodiment, the m' test elements are arranged in one column, and accordingly, one second calibration mark 9' is provided in the test component region TGA. The second calibration mark 9' is used to measure the position accuracy of the m' test elements arranged in one column along the first direction D1.

It will be noted that the calibration or positioning using the reference mark 7', the first calibration mark 8' and the second calibration mark 9' will be further described in detail below with reference to a measurement process.

Referring back to FIG. 2, in some embodiments, the first light-emitting sub-layer 53'R, the second light-emitting sub-layer 53'G and the third light-emitting sub-layer 53'B may be formed through evaporation processes using different FMMs, respectively.

In the display region AA, the compensation sub-layer 56'R is located below the first light-emitting sub-layer 53'R, and the compensation sub-layer 56'R is consistent with the first light-emitting sub-layer 53'R in terms of the position in the first direction D1 and the position in the second direction D2. Thus, the compensation sub-layer 56'R and the first light-emitting sub-layer 53'R may be formed using the same FMM. It will be noted that different evaporation process parameters are adopted in the formation of the compensation sub-layer 56'R and the formation of the first light-emitting sub-layer 53'R. Therefore, the compensation sub-layer 56'R and the first light-emitting sub-layer 53'R are formed through different evaporation processes. Likewise, the compensation sub-layer 56'G is located below the second light-emitting sub-layer 53'G, and the compensation sub-layer 56'G is consistent with the second light-emitting sub-layer 53'G in terms of the position in the first direction D1 and the position in the second direction D2. Thus, the compensation sub-layer 56'G and the second light-emitting sub-layer 53'G may be formed using the same FMM. It will be noted that different evaporation process parameters are used in the formation of the compensation sub-layer 56'G and the second light-emitting sub-layer 53'G. Therefore, the compensation sub-layer 56'G and the second light-emitting sub-layer 53'G are formed through different evaporation processes.

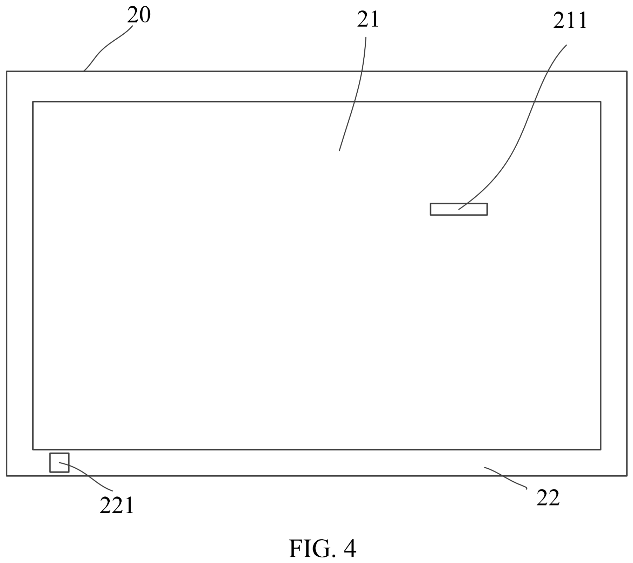

FIG. 4 schematically shows a schematic structural diagram of a mask used in an evaporation process according to some exemplary embodiments of the present disclosure.

As shown in FIG. 4, a mask 20 includes an evaporation region 21 and a test region 22 around the evaporation region 21. The evaporation region 21 is provided with an evaporation opening 211, which allows a target material to pass through and reach a pattern region of the backplane, so as to form a pattern of the light-emitting layer or a pattern of the compensation layer in the display region AA. The test region 22 is provided with a test hole 221, which allows the target material to pass through and reach the test component region of the backplane, so as to form a pattern of the test element in the test component region TGA.

In practical applications, the mask 20 is fixed in a chamber, the target material is provided below the mask 20, and the backplane to be evaporated is provided above the mask 20. By setting appropriate process conditions in the chamber, it is possible to ensure that the target material is evaporated to a predetermined position on the backplane through the evaporation opening and the test hole in the mask 20. For example, the mask 20 may be an FMM. During the evaporation, thermally evaporated organic material molecules may pass through the evaporation opening 211 in the FMM and then be deposited to an opening in the pixel defining layer of the backplane, so as to form a pattern of the light-emitting layer or a pattern of the compensation layer in the display region AA. At the same time, organic material molecules may pass through the test hole 221 in the FMM and then be deposited to the test component region of the backplane, so as to form a pattern of the test element in the test component region TGA. The plurality of test elements in the test component region TGA may form position test marks, which are used for accurate test alignment of the evaporation pattern formed by evaporation using the FMM. Each evaporation pattern corresponds to a test element, so as to ensure the correctness and accuracy of the evaporation pattern.

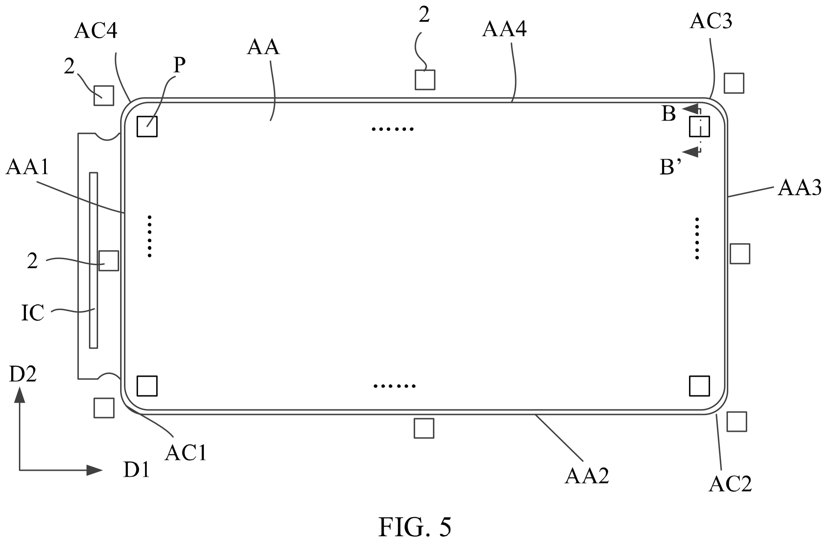

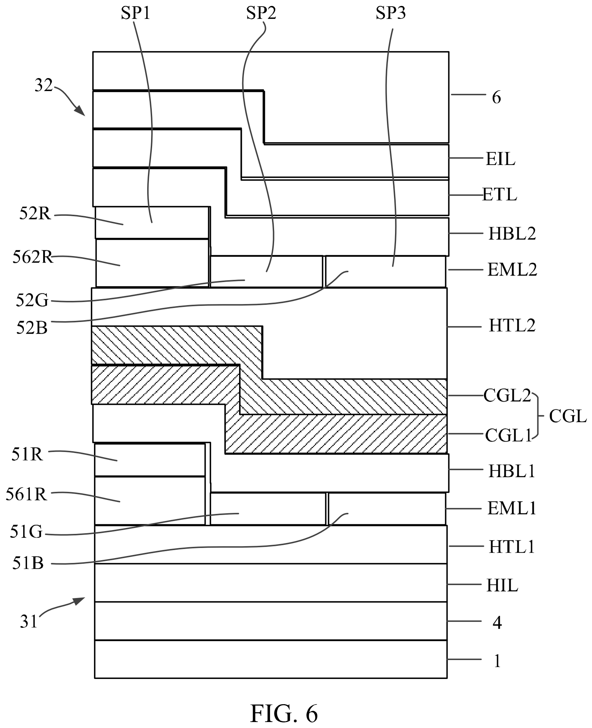

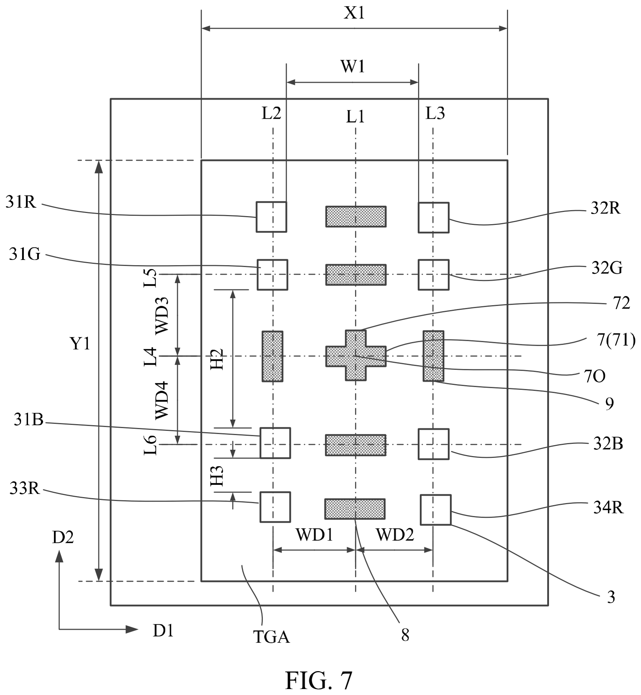

FIG. 5 shows a schematic top view of a display substrate according to some other exemplary embodiments of the present disclosure, FIG. 6 shows a schematic cross-sectional view of a display substrate taken along line BB' in FIG. 5 according to some other exemplary embodiments of the present disclosure, and FIG. 7 shows a partial enlarged view of a test component region in a display substrate according to some other exemplary embodiments of the present disclosure.

Referring to FIG. 5 to FIG. 7 in combination, the display substrate 100 includes: a base substrate 1 including a display region AA and a test component region TGA; a plurality of pixel units P on the base substrate 1, where the plurality of pixel units P are arranged in the display region AA in an array along the first direction D1 and the second direction D2; and at least one test component 2 on the base substrate 1, where the at least one test component 2 is located in the test component region TGA, and the at least one test component 2 includes a plurality of test elements 3 arranged in the test component region TGA in an array along the first direction D1 and the second direction D2.

In this embodiment, at least one pixel unit P includes a plurality of light-emitting elements stacked along a third direction D3, and the plurality of light-emitting elements stacked along the third direction D3 include: a charge generation layer CGL on the base substrate 1; a first light-emitting layer on a side of the charge generation layer CGL close to the base substrate 1; and a second light-emitting layer on a side of the charge generation layer CGL away from the base substrate 1. The first direction D1 intersects with the second direction D2, and the third direction D3 is perpendicular to each of the first direction D1 and the second direction D2.

As shown in FIG. 5, in the display region AA, the display substrate 100 includes: a first electrode 4, a second electrode 6, and a first light-emitting layer, a charge generation layer CGL and a second light-emitting layer that are sandwiched between the first electrode 4 and the second electrode 6, where the first electrode 4, the second electrode 6, the first light-emitting layer, the charge generation layer CGL and the second light-emitting layer are arranged on the base substrate 1. In the third direction D3, the first light-emitting layer is located between the first electrode 4 and the charge generation layer CGL, and the second light-emitting layer is located between the charge generation layer CGL and the second electrode 6.

In other words, in at least one pixel unit P, the OLED light-emitting device includes two light-emitting elements connected in series, so that the OLED light-emitting device is formed as a Tandem device. For example, an upper light-emitting element 32 includes a second electrode 6, an electron injection layer EIL, an electron transport layer ETL, a hole blocking layer HBL2, a second light-emitting layer EML2, a hole transport layer HTL2 and a charge generation layer CGL, and a lower light-emitting element 31 includes a charge generation layer CGL, a hole blocking layer HBL1, a first light-emitting layer EML1, a hole transport layer HTL1, a hole injection layer HIL and a first electrode 4.

For example, the charge generation layer CGL may include an N-type charge generation layer CGL1 and a P-type charge generation layer CGL2, and the N-type charge generation layer CGL1 is arranged on a side of the P-type charge generation layer CGL2 close to the first electrode 4. That is, the N-type charge generation layer CGL1 is paired with the first electrode 4 to excite the lower light-emitting element to emit light. The P-type charge generation layer CGL2 is paired with the second electrode 6 to excite the upper light-emitting element to emit light.

For example, the N-type charge generation layer CGL1 may be made of an organic electron transport material doped with a metal material, with a doping concentration less than or equal to 1%. The P-type charge generation layer CGL2 may be made of an organic hole transport material doped with PD (p-dopant), with a doping concentration of about 10%.

In other words, as shown in FIG. 6, the display substrate 100 includes: the first electrode 4 on the base substrate 1; the hole injection layer HIL on a side of the first electrode 4 away from the base substrate; the first hole transport layer HTL1 on a side of the hole injection layer HIL away from the base substrate; the first light-emitting layer EML1 on a side of the first hole transport layer HTL1 away from the base substrate; the first hole blocking layer HBL1 on a side of the first light-emitting layer EML1 away from the base substrate; the N-type charge generation layer CGL1 on a side of the first hole blocking layer HBL1 away from the base substrate; the P-type charge generation layer CGL2 on a side of the N-type charge generation layer CGL1 away from the base substrate; the second hole transport layer HTL2 on a side of the P-type charge generation layer CGL2 away from the base substrate; the second light-emitting layer EML2 on a side of the second hole transport layer HTL2 away from the base substrate; the second hole blocking layer HBL2 on a side of the second light-emitting layer EML2 away from the base substrate; the electron transport layer ETL on a side of the second hole blocking layer HBL2 away from the base substrate; the electron injection layer EIL on a side of the electron transport layer ETL away from the base substrate; and the second electrode 6 on a side of the electron injection layer EIL away from the base substrate.

In some embodiments of the present disclosure, the first light-emitting layer EML1 includes first light-emitting sub-layers of more than one color, for example, the first light-emitting sub-layers of more than one color may include light-emitting sub-layers 51R, 51G and 51B. The second light-emitting layer EML2 includes second light-emitting sub-layers of more than one color, for example, the second light-emitting sub-layers of more than one color may include light-emitting sub-layers 52R, 52G and 52B.

In this embodiment, the OLED light-emitting device is formed as a Tandem device, in which two or more light-emitting elements are connected in series through the charge generation layer to form a stacked device. As the number of light-emitting layers increases and the charge generation layer may reduce a driving voltage and generate new carriers, stacking a plurality of light-emitting elements may multiply the light emission efficiency of the device and greatly improve the light emission efficiency of the device. At a same luminance, a current density of the Tandem device may be reduced, which may significantly increase the lifespan of the device.

For example, the light-emitting sub-layers 51R, 51G and 51B may emit red light, green light and blue light, respectively. The light-emitting sub-layers 52R, 52G and 52B may emit red light, green light and blue light, respectively.

In this embodiment, a pixel unit P may include at least three sub-pixels SP1, SP2 and SP3, which are a red sub-pixel, a green sub-pixel and a blue sub-pixel respectively. The sub-pixel SP1 includes stacked light-emitting sub-layers 51R and 52R, the sub-pixel SP2 includes stacked light-emitting sub-layers 51G and 52G, and the sub-pixel SP3 includes stacked light-emitting sub-layers 51B and 52B.

It will be noted that the embodiments of the present disclosure do not impose special limitations on the design of the pixel unit P. For example, it is shown in the accompanying drawings that the pixel unit P includes three sub-pixels. However, in other embodiments, a pixel unit P may include fewer or more sub-pixels. In addition, the sub-pixels in a pixel unit P may be arranged in various manners known in the art, which are not specifically limited in embodiments of the present disclosure.

In some exemplary embodiments of the present disclosure, at least one light-emitting element stacked along the third direction may further include: a first compensation layer on a side of the first light-emitting layer EML1 close to the base substrate; and a second compensation layer on a side of the second light-emitting layer EML2 close to the base substrate.

As the red light, the green light and the blue light have different wavelengths, they may experience different losses when passing through structures above the light-emitting layer, and the larger the wavelength, the greater the loss. To ensure the same display effect across the respective pixel units P under the same conditions, in some embodiments of the present disclosure, it is possible to increase a luminance intensity of the red sub-pixel and/or the green sub-pixel, so as to compensate for the transmission loss. That is, a compensation layer may be added below the light-emitting sub-layer of the red sub-pixel and/or the light-emitting sub-layer of the green sub-pixel.

For example, in the embodiment shown in FIG. 6, at least one light-emitting element in the first sub-pixel SP1 may include a compensation layer, that is, including a first compensation sub-layer 561R on a side of the first light-emitting layer EML1 close to the base substrate and a second compensation sub-layer 562R on a side of the second light-emitting layer EML2 close to the base substrate.

The first compensation sub-layer 561R is located below the light-emitting sub-layer 51R. In other words, the first compensation sub-layer 561R is located between the light-emitting sub-layer 51R and the first electrode 4. For example, a thickness of the first compensation sub-layer 561R is greater than that of the light-emitting sub-layer 51R. When the holes transported by the first electrode 4 and the electrons transported by the N-type charge generation layer CGL1 are recombined in the first compensation sub-layer 561R, the first compensation sub-layer 561R may be excited to emit the red light, so as to enhance the intensity of the red light emitted by the first sub-pixel SP1.

Referring to FIG. 5 to FIG. 7, the display region AA of the display substrate 100 includes a first edge AA1, a second edge AA2, a third edge AA3, a fourth edge AA4, a first corner AC1, a second corner AC2, a third corner AC3 and a fourth corner AC4. Each of the first corner AC1, the second corner AC2, the third corner AC3 and the fourth corner AC4 is respectively located at a respective junction of two adjacent edges among the first edge AA1, the second edge AA2, the third edge AA3 and the fourth edge AA4.

In some embodiments, the display substrate 100 may include a plurality of test components 2, which are arranged to be respectively adjacent to the first edge AA1, the second edge AA2, the third edge AA3, the fourth edge AA4, the first corner AC1, the second corner AC2, the third corner AC3 and the fourth corner AC4.

FIG. 7 schematically shows a partial enlarged view of a test component region. As shown in FIG. 7, at least one test component region TGA is provided with a test component 2, which may include a plurality of test element 3. For example, the plurality of test elements 3 may be test elements of more than one color. For ease of description, the test elements of more than one color are denoted as test elements 31R, 32R, 31G, 32G, 31B, 32B, 33R and 34R respectively.

The test elements 31R, 32R, 31G, 32G, 31B, 32B, 33R and 34R of more than one color respectively correspond to the light-emitting sub-layer 51R, the light-emitting sub-layer 52R, the light-emitting sub-layer 51G, the light-emitting sub-layer 52G, the light-emitting sub-layer 51B, the light-emitting sub-layer 52B, the first compensation sub-layer 561R and the second compensation sub-layer 562R formed using an evaporation process. Specifically, in the manufacturing process of the display substrate 100, the light-emitting sub-layer 51R, the light-emitting sub-layer 52R, the light-emitting sub-layer 51G, the light-emitting sub-layer 52G, the light-emitting sub-layer 51B, the light-emitting sub-layer 52B, the first compensation sub-layer 561R and the second compensation sub-layer 562R are formed through multiple evaporation processes. It will be noted that the expression of "multiple evaporation processes" here means that during the multiple evaporation processes, different FMMs are employed to form the evaporated film layers, or the same FMM is employed but with different evaporation process parameters to form the evaporated film layers.

In this embodiment, the test element 31R and the light-emitting sub-layer 51R are formed by the same evaporation process, the test element 32R and the light-emitting sub-layer 52R are formed by the same evaporation process, the test element 31G and the light-emitting sub-layer 51G are formed by the same evaporation process, the test element 32G and the light-emitting sub-layer 52G are formed by the same evaporation process, the test element 31B and the light-emitting sub-layer 51B are formed by the same evaporation process, the test element 32B and the light-emitting sub-layer 52B are formed by the same evaporation process, the test element 33R and the first compensation sub-layer 561R are formed by the same evaporation process, and the test element 34R and the second compensation sub-layer 562R are formed by the same evaporation process. Accordingly, it is possible to determine the pixel position accuracy of the light-emitting sub-layer 51R by measuring the position accuracy of the test element 31R, determine the pixel position accuracy of the light-emitting sub-layer 52R by measuring the position accuracy of the test element 32R, determine the pixel position accuracy of the light-emitting sub-layer 51G by measuring the position accuracy of the test element 31G, determine the pixel position accuracy of the light-emitting sub-layer 52G by measuring the position accuracy of the test element 32G, determine the pixel position accuracy of the light-emitting sub-layer 51B by measuring the position accuracy of the test element 31B, determine the pixel position accuracy of the light-emitting sub-layer 52B by measuring the position accuracy of the test element 32B, determine the pixel position accuracy of the first compensation sub-layer 561R by measuring the position accuracy of the test element 33R, and determine the pixel position accuracy of the second compensation sub-layer 562R by measuring the position accuracy of the test element 34R.

In the embodiments of the present disclosure, the test element in the test component region is formed through the same evaporation process as the light-emitting layer or light-emitting sub-layer in the display region. Therefore, the test element and the light-emitting layer or the light-emitting sub-layer formed through the same evaporation process include the same material, and have substantially the same thickness. It will be noted that the expression of "substantially the same thickness" here may be understood as that the test element and the light-emitting layer or the light-emitting sub-layer formed through the same evaporation process have approximately the same thickness in their respective central portions, but there may be slight differences in thickness at their respective edge portions due to different diffusion regions.

As shown in FIG. 7, a test component region TGA has a first size X1 in the first direction D1 and a second size Y1 in the second direction D2.

It will be noted that, in the embodiments of the present disclosure, the expression of "test component region" refers to a region where the test component is placed, and a size thereof is limited by a field of view of the image acquisition sensor (such as CCD) of the testing apparatus.

For example, the first size and the second size of a single test component region TGA in the embodiments shown in FIG. 5 to FIG. 7 are respectively equal to the first size and the second size of a single test component region TGA in the embodiments shown in FIG. 1 to FIG. 3.

It will be further noted that, in the embodiments of the present disclosure, for example, the test component region TGA has a rectangular shape, and the first size X1 of the test component region TGA is smaller than the second size Y1. The embodiments of the present disclosure are not limited to this, and the test component region TGA may also have other shapes, such as a polygon, a circle, etc.

As shown in FIG. 7, in a test component region TGA, the test elements 31R, 32R, 31G, 32G, 31B, 32B, 33R and 34R are arranged in the test component region TGA in an array along the first direction D1 and the second direction D2.

For example, the test elements 31R, 32R, 31G, 32G, 31B, 32B, 33R and 34R are divided into two columns which are arranged along the first direction. For example, referring to FIG. 7, a left column of test elements is referred to as a first column, and a right column of test elements is referred to as a second column. Test elements corresponding to the light-emitting layer and/or the compensation layer of the lower light-emitting element 31 in the Tandem structure may be arranged in the first column, and test elements corresponding to the light-emitting layer and/or the compensation layer of the upper light-emitting element 32 in the Tandem structure may be arranged in the second column. Specifically, the test elements 31R, 31G, 31B and 33R are arranged in the first column, and the test elements 32R, 32G, 32B and 34R are arranged in the second column.

In the embodiments of the present disclosure, in the display substrate having the Tandem structure, as the number of film layers formed using the evaporation process increases, the number of test elements required in the test component region increases. For example, in the embodiments shown in FIG. 5 to FIG. 7, as the number of film layers in the display region formed using the evaporation process increases to 8, the number of the test elements arranged in the test component region increases to 8. When the number of the test elements increases, it is possible to change the arrangement of the test elements from a single-column arrangement to a multi-column arrangement, so as to perform a pixel position accuracy measurement of the display substrate having the Tandem structure without changing the size of a single test component region.

It will be noted that FIG. 7 schematically shows a shape of an orthographic projection of each test element on the base substrate 1, which is schematically shown as a square. However, the embodiments of the present disclosure are not limited to this, and the shape of the orthographic projection of each test element on the base substrate 1 may include but is not limited to a rectangle, a circle, an ellipse, an approximately circular shape, a triangle, a rhombus, a trapezoid, a parallelogram, a pentagon, a hexagonal and other shapes.

It will be noted that in the present disclosure, for ease of description, the test elements 31R, 31G and 31B corresponding to the light-emitting layer of the lower light-emitting element 31 in the Tandem structure are referred to as first test elements, the test elements 32R, 32G and 32B corresponding to the light-emitting layer of the upper light-emitting element 32 in the Tandem structure are referred to as second test elements, the test element 33R corresponding to the compensation layer of the lower light-emitting element 31 in the Tandem structure is referred to as a third test element, and the test element 34R corresponding to the compensation layer of the upper light-emitting element 32 in the Tandem structure is referred to as a fourth test element.

Referring to FIG. 7, the first test element and the second test element within the same test component and having the same color are arranged in two columns that are arranged along the first direction D1, and the first test element and the second test element of the same test component and having the same color are arranged in a row extending along the first direction D1. Specifically, the first test element 31R and the second test element 32R having the same color are arranged in two columns arranged along the first direction D1, and the first test element 31R and the second test element 32R are also arranged in a row extending along the first direction D1. The first test element 31G and the second test element 32G having the same color are arranged in two columns arranged along the first direction D1, and the first test element 31G and the second test element 32G are also arranged in a row extending along the first direction D1. The first test element 31B and the second test element 32B having the same color are arranged in two columns arranged along the first direction D1, and the first test element 31B and the second test element 32B are also arranged in a row extending along the first direction D1.

The first test elements within a same test component and having different colors are arranged in the same column extending along the second direction. For example, the first test elements 31R, 31G and 31B having different colors are arranged in the same column extending along the second direction D2. Additionally, or alternatively, the second test elements within a test component and having different colors are arranged in the same column extending along the second direction. For example, the second test elements 32R, 32G and 32B having different colors are arranged in the same column extending along the second direction D2.

The third test element 33R and the fourth test element 34R having the same color are arranged in two columns that are arranged along the first direction D1, and the third test element 33R and the fourth test element 34R are also arranged in a row extending along the first direction D1.

With continued reference to FIG. 7, the display substrate 100 may further include a reference mark 7, a first calibration mark 8 and a second calibration mark 9 on the base substrate 1. The reference mark 7, the first calibration mark 8 and the second calibration mark 9 are all located in the test component region TGA.

The reference mark 7 may include a first reference mark portion 71 extending along the first direction D1 and a second reference mark portion 72 extending along the second direction D2. The first reference mark portion 71 and the second reference mark portion 72 intersect at a reference point 7O.

The first calibration mark 8 extends along the first direction D1, and the second calibration mark 9 extends along the second direction D2.

For example, the reference mark 7 may have a shape of a cross, and the first calibration mark 8 and second calibration mark 9 may each have a linear shape.

In some embodiments, m evaporated film layers are provided in the display region AA, where m is a positive integer greater than or equal to 1. For example, in the embodiments shown in FIG. 5 to FIG. 7, m is 8, and the eight evaporated film layers are respectively the light-emitting sub-layer 51R, the light-emitting sub-layer 52R, the light-emitting sub-layer 51G, the light-emitting sub-layer 52G, the light-emitting sub-layer 51B, the light-emitting sub-layer 52B, the first compensation sub-layer 561R and the second compensation sub-layer 562R. Accordingly, in the test component region TGA, the test component includes m test elements, which respectively correspond to the m evaporated film layers and are respectively used to measure the pixel position accuracy of the m evaporated film layers.

In the embodiments of the present disclosure, the at least one test component includes q columns of test elements arranged in the first direction D1 and n rows of test elements arranged in the second direction, where q is a positive integer greater than or equal to 2, and n is a positive integer greater than or equal to 4. In the embodiment shown in FIG. 7, q = 2, n = 4. It will be understood that m = q × n.

In the embodiments of the present disclosure, the test component region TGA is provided with only one reference mark 7, which is used for calibrating the position of the test component region TGA.

The at least one test component region TGA is provided with n first calibration marks 8, that is, the number of first calibration marks 8 is consistent with the number of rows of test elements. The n first calibration marks 8 correspond to the n rows of test elements respectively and are used to measure the position accuracy of the n rows of test elements in the second direction D2.

The at least one test component region TGA is provided with q second calibration marks 9, that is, the number of second calibration marks 9 is consistent with the number of columns of the test element. The q second calibration marks 9 corresponds to the q columns of test elements respectively and are used to measure the position accuracy of the q columns of test elements in the first direction D1.

Exemplarily, the reference mark 7 is located substantially at a center of the test component region TGA. In the first direction D1, the reference mark 7 is located between two adjacent columns of test elements; and in the second direction D2, the reference mark 7 is located between two adjacent rows of test elements.

A position of each of the n first calibration marks 8 corresponds to a position of a respective row of the n rows of test elements. Specifically, each of the n first calibration marks 8 is located between two adjacent columns of test elements in the first direction D1. That is, in the first direction D1, an i^{th} first calibration mark 8 is located between the first test element and the second test element in an i^{th} row of test element, where 1 ≤ i ≤ n, and i is a positive integer. With such an arrangement, the position accuracy of more than one test element within a row may be measured using one first calibration mark, and the more than one test element and the first calibration mark may be compactly arranged.

As shown in FIG. 7, the test component region TGA is provided with four first calibration marks 8, where two first calibration marks 8 are located above the reference mark 7 in the second direction, and the remaining two first calibration marks 8 are located below the reference mark 7 in the second direction.

A position of each of the q second calibration marks 9 corresponds to a position of a respective column of the q columns of test elements. Specifically, in the first direction D1, a j^{th} second calibration mark 9 is aligned with a j^{th} column of test elements; and in the second direction D2, the j^{th} second calibration mark 9 is located between two adjacent test elements in the j^{th} column of test elements, where 1 ≤ j ≤ q, and j is a positive integer. With such an arrangement, the position accuracy of more than one test element within a column may be measured using one second calibration mark, and the more than one test element and the second calibration mark may be compactly arranged.

As shown in FIG. 7, the test component region TGA is provided with two second calibration marks 9. In the second direction D2, the two second calibration marks 9 are located between a second row of test elements and a third row of test elements; and in the first direction D1, one second calibration mark 9 is located on a left side of the reference mark 7, and the other second calibration mark 9 is located on a right side of the reference mark 7.

In the embodiments of the present disclosure, the plurality of test elements are manufactured through an evaporation process using an FMM, and it is necessary for the test elements to be within the field of view of the CCD of the testing apparatus when in use. Based on this, in a case that the size of a single test component region TGA remains unchanged, it is needed to design an arrangement and a size of the plurality of test elements in the test component region TGA, and also a spacing therebetween.

As shown in FIG. 7, the test component region TGA has a first size X1 in the first direction D1 and a second size Y1 in the second direction D2. The first size X1 and the second size Y1 are designed to meet the following requirements: when the CCD of the testing apparatus captures an image of the test component region TGA, an image of the entire test component region TGA may be acquired through a single shot.

Due to limitations of processing precision of an evaporation process using an FMM, the test elements need to be designed to be spaced apart from each of the edges of the test element region TGA by a particular distance, that is, a particular margin is required. For example, as shown in FIG. 7, the test elements 31R and 32R in a first row at the top need to be spaced apart from an upper edge of the test element region TGA by a particular distance, which is recorded as a top margin; the test elements 33R and 34R in a fourth row at the bottom need to be spaced apart from a lower edge of the test element region TGA by a particular distance, which is recorded as a bottom margin; the test elements in a first column on the left side need to be spaced apart from a left edge of the test element region TGA by a particular distance, which is recorded as a left margin; the test elements in a second column on the right side need to be spaced apart from a right edge of the test element region TGA by a particular distance, which is recorded as a right margin. For example, any two of the top margin, the bottom margin, the left margin and the right margin are substantially equal to each other. In other words, a ratio of any two of the top margin, the bottom margin, the left margin and the right margin ranges from 0.8 to 1.2. For example, any one of the top margin, the bottom margin, the left margin and the right margin is greater than or equal to 20 microns.

With continued reference to FIG. 7, in the same test component, i.e., in a single test component region TGA, a first spacing W1 in the first direction D1 between two columns of test elements arranged along the first direction D1 needs to meet some design requirements. Specifically, when forming the test elements through an evaporation process using an FMM, due to processing precision and other factors, individual test elements may have a particular processing precision error, and a single-side margin tolerance needs to be reserved on each side of each test element. Based on this, the first spacing W1 may be greater than or equal to 150 microns, so as to ensure that two adjacent columns of test elements do not overlap. Further, the first spacing W1 may be less than or equal to 390 microns, so as to ensure that two columns of test elements may be arranged within a range of a single test component region TGA.

With continued reference to FIG. 7, the n rows of test elements include a k^{th} row of test elements adjacent to the reference mark 7 and a (k+1)^{th} row of test elements adjacent to the reference mark 7, or in other words, a k^{th} row of test elements adjacent to the second calibration mark 9 and a (k+1)^{th} row of test elements adjacent to the second calibration mark 9. The k^{th} row of test elements is spaced apart from the (k+1)^{th} row of test elements by a second spacing H2 in the second direction D2, where 1 ≤ k ≤ n-1, and k is a positive integer. For example, in the embodiments of FIG. 7, k = 2, that is, a second row of test elements is spaced apart from a third row of test elements by the second spacing H2 in the second direction D2.

A p^{th} row of test elements is spaced apart from a (p+1)^{th} row of test elements by a third spacing H3 in the second direction D2, where 1 ≤ p ≤ n-1, p is a positive integer, and p is not equal to k. For example, in the embodiment of FIG. 7, p may be equal to 1. That is, the first row of test elements is spaced apart from the second row of test elements by a third spacing H3 in the second direction D2. Also, p may be equal to 3, that is, the third row of test elements is spaced apart from the fourth row of test elements by the third spacing H3 in the second direction D2.

In the embodiments of the present disclosure, the second spacing H2 is greater than the third spacing H3. Specifically, the second spacing H2 is at least twice the third spacing H3. With such a design, on the one hand, a relatively large space may be provided to arrange a row of second calibration marks 9, and on the other hand, more than one row of test elements may be arrange compactly in the second direction, which is conducive to an arrangement of more than one row of test elements in the test component region TGA.

With continued reference to FIG. 7, a first imaginary line L1 extends along the second direction D2 and passes through the reference point 7O, a second imaginary line L2 extends along the second direction D2 and passes through centers of at least two test elements in a column of test elements (e.g., the first column of test elements on the left side), and a third imaginary line L3 extends along the second direction D2 and passes through centers of at least two test elements in another column of test elements (e.g., the second column of test elements on the right side).

In the embodiments of the present disclosure, a first distance WD1 between the second imaginary line L2 and the first imaginary line L1 in the first direction D1 is substantially equal to a second distance WD2 between the third imaginary line L3 and the first imaginary line L1 in the first direction D1. In other words, a ratio of the first distance WD1 to the second distance WD2 ranges from 0.8 to 1.2.

With continued reference to FIG. 7, a fourth imaginary line L4 extends along the first direction D1 and passes through the reference point 7O, a fifth imaginary line L5 extends along the first direction D1 and passes through centers of test elements of a row of test elements (e.g., the second row of test elements) adjacent to the reference mark 7, and a sixth imaginary line L6 extends along the first direction D1 and passes through centers of test elements of another row of test elements (e.g., the third row of test elements) adjacent to the reference mark 7.

In the embodiments of the present disclosure, a third distance WD3 between the fifth imaginary line L5 and the fourth imaginary line L4 in the second direction D2 is substantially equal to a fourth distance WD4 between the sixth imaginary line L6 and the fourth imaginary line L4 in the second direction D2. In other words, a ratio of the third distance WD3 to the fourth distance WD4 ranges from 0.8 to 1.2.

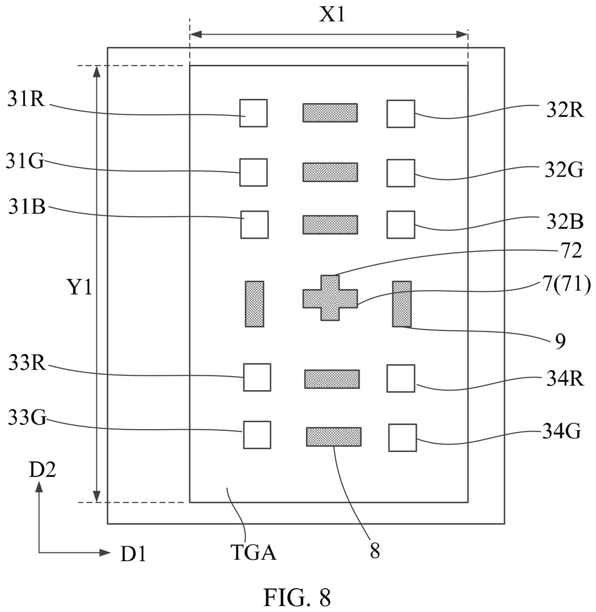

FIG. 8 shows a partial enlarged view of a test component region in a display substrate according to some other exemplary embodiments of the present disclosure.

As shown in FIG. 8, at least one test component includes q columns of test elements arranged along the first direction D1 and n rows of test elements arranged along the second direction, where q is a positive integer greater than or equal to 2, and n is a positive integer greater than or equal to 4. For example, q=2, and n=5.

For example, in some embodiments, the first compensation sub-layer on the side of the first light-emitting layer EML1 close to the base substrate may be arranged in the first sub-pixel SP1 and the second sub-pixel SP2, and the second compensation sub-layer on the side of the second light-emitting layer EML2 close to the base substrate may be arranged in the first sub-pixel SP1 and the second sub-pixel SP2. That is, it is possible to enhance the luminance intensity of the red sub-pixel and the green sub-pixel, so as to compensate for the transmission loss.

In the embodiment shown in FIG. 8, a plurality of test elements 3 may be test elements of more than one color. For ease of description, the test elements of more than one color may be denoted as test elements 31R, 32R, 31G, 32G, 31B, 32B, 33R, 34R, 33G and 34G respectively. The test elements 31R, 32R, 31G, 32G, 31B, 32B, 33R, 34R, 33G and 34G respectively correspond to the light-emitting sub-layer 51R, the light-emitting sub-layer 52R, the light-emitting sub-layer 51G, the light-emitting sub-layer 52G, the light-emitting sub-layer 51B, the light-emitting sub-layer 52B, a portion of the first compensation sub-layer in the first sub-pixel, a portion of the second compensation sub-layer in the first sub-pixel, a portion of the first compensation sub-layer in the second sub-pixel, and a portion of the second compensation sub-layer in the second sub-pixel, which are all formed by evaporation.

Referring to FIG. 7 and FIG. 8 in combination, a size of the test component region TGA, a size of the test elements, and a spacing between the test elements may remain unchanged.

The reference mark 7 is located substantially at the center of the test component region TGA. In the first direction D1, the reference mark 7 is located between two adjacent columns of test elements; and in the second direction D2, the reference mark 7 is located between two adjacent rows of test elements.

A position of each of five first calibration marks 8 corresponds to a position of a respective row of five rows of test elements. Specifically, in the first direction D1, each of the five first calibration marks 8 is located between two adjacent columns of test elements. That is, in the first direction D1, an i^{th} first calibration mark 8 is located between the first test element and the second test element in an i^{th} row of test elements, where 1 ≤ i ≤ 5, and i is a positive integer. With such an arrangement, the position accuracy of more than one test element within a row may be measured using one first calibration mark, and the more than one test element and the first calibration mark may be compactly arranged.

As shown in FIG. 8, the test component region TGA is provided with five first calibration marks 8, where three first calibration marks 8 are located above the reference mark 7 in the second direction, and the remaining two first calibration marks 8 are located below the reference mark 7 in the second direction.

A position of each of two second calibration marks 9 corresponds to a position of a respective column of two columns of test elements. Specifically, in the first direction D1, a j^{th} second calibration mark 9 is aligned with a j^{th} column of test elements; and in the second direction D2, the j^{th} second calibration mark 9 is located between two adjacent test elements in the j^{th} column of test elements, where 1 ≤ j ≤ 2, and j is a positive integer. With such an arrangement, the position accuracy of more than one test element within a column may be measured using one second calibration mark, and the more than one test element and the second calibration mark may be compactly arranged.

As shown in FIG. 8, the test component region TGA is provided with two second calibration marks 9. In the second direction D2, the two second calibration marks 9 are located between the third row of test elements and the fourth row of test elements; and in the first direction D1, one second calibration mark 9 is located on the left side of the reference mark 7, and the other second calibration mark 9 is located on the right side of the reference mark 7.

In the embodiments of the present disclosure, the plurality of test elements are manufactured through an evaporation process using an FMM, and it is necessary for the test elements to be within the field of view of the CCD of the testing apparatus when in use. Based on this, in a case that the size of a single test component region TGA remains unchanged, it is needed to design the arrangement and a size of the plurality of test elements in the test component region TGA, and also a spacing therebetween.

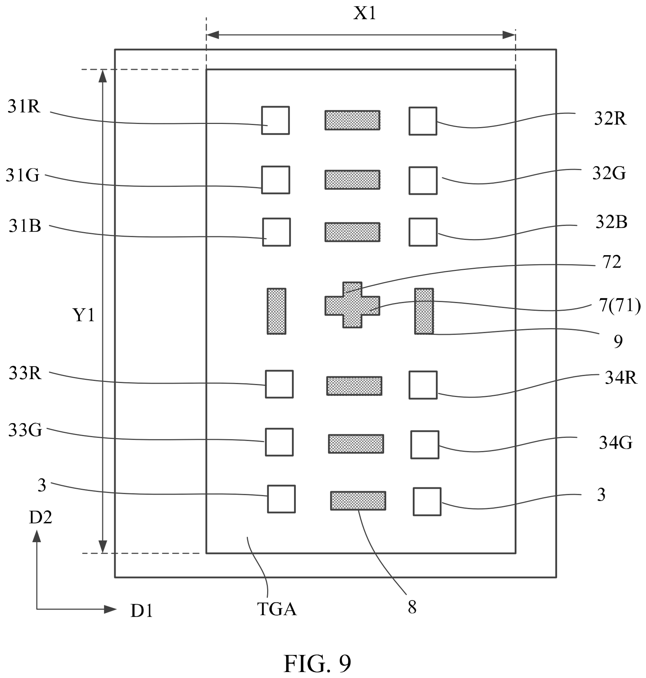

FIG. 9 shows a partial enlarged view of a test component region in a display substrate according to some other exemplary embodiments of the present disclosure.

As shown in FIG. 9, at least one test component includes q columns of test elements arranged along the first direction D1 and n rows of test elements arranged along the second direction D2, where q is a positive integer greater than or equal to 2, and n is a positive integer greater than or equal to 4. For example, q=2, and n=6.

Referring to FIG. 7, FIG. 8 and FIG. 9, compared to FIG. 7 and FIG. 8, the size of the test component region TGA in FIG. 9 remains unchanged, while at least part of the size of the test elements and the spacing between the test elements may be reduced so that a plurality of elements arranged in six rows and two columns may be arranged within the single test component region TGA with unchanged size.

The reference mark 7 is located substantially at the center of the test component region TGA. In the first direction D1, the reference mark 7 is located between two adjacent columns of test elements; and in the second direction D2, the reference mark 7 is located between two adjacent rows of test elements.

A position of each of six first calibration marks 8 corresponds to a position of a respective row of the six rows of test elements. Specifically, each of the six first calibration marks 8 is located between two adjacent columns of test elements in the first direction D1. That is, in the first direction D1, an i^{th} first calibration mark 8 is located between the first test element and the second test element in an i^{th} row of test elements, where 1 ≤ i ≤ 6, and i is a positive integer. With such an arrangement, the position accuracy of more than one test element within a row may be measured using one first calibration mark, and the more than one test element and the first calibration mark may be compactly arranged.

As shown in FIG. 9, the test component region TGA is provided with six first calibration marks 8, where three first calibration marks 8 are located above the reference mark 7 in the second direction, and the remaining three first calibration marks 8 are located below the reference mark 7 in the second direction.

A position of each of two second calibration marks 9 corresponds to a position of a respective column of two columns of test elements. Specifically, in the first direction D1, a j^{th} second calibration mark 9 is aligned with a j^{th} column of test elements; and in the second direction D2, the j^{th} second calibration mark 9 is located between two adjacent test elements in the j^{th} column of test elements, where 1 ≤ j ≤ 2, and j is a positive integer. With such an arrangement, the position accuracy of more than one test element within a column may be measured using one second calibration mark, and the more than one test element and the second calibration mark may be compactly arranged.

As shown in FIG. 9, the test component region TGA is provided with two second calibration marks 9. In the second direction D2, the two second calibration marks 9 are located between the third row of test elements and the fourth row of test elements; and in the first direction D1, one second calibration mark 9 is located on the left side of the reference mark 7, and the other second calibration mark 9 is located on the right side of the reference mark 7.

In the embodiments of the present disclosure, the plurality of test elements are manufactured through an evaporation process using an FMM, and it is necessary for the test elements to be within the field of view of the CCD of the testing apparatus when in use. Based on this, in a case that the size of a single test component region TGA remains unchanged, it is needed to design an arrangement and a size of the plurality of test elements in the test component region TGA, and also the a spacing therebetween.

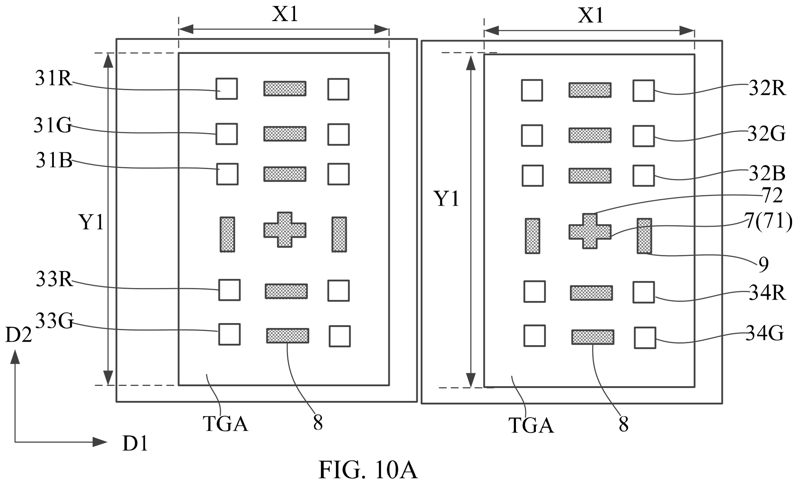

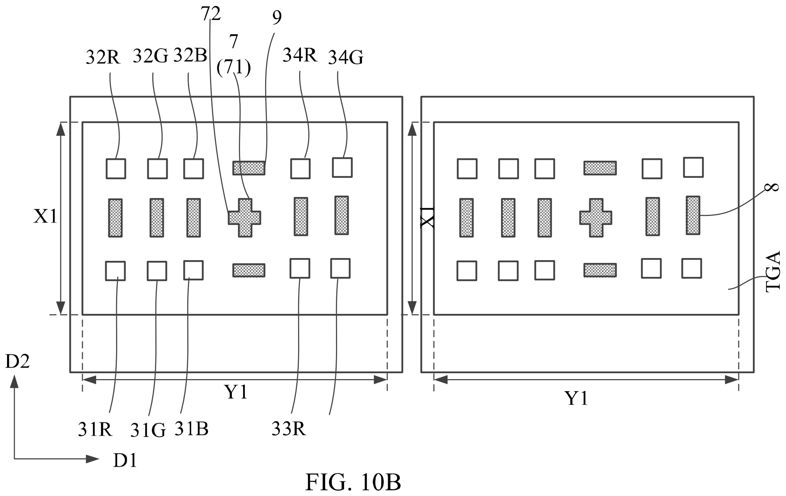

FIG. 10A and FIG. 10B respectively show partial enlarged views of a test component region in a display substrate according to yet some other exemplary embodiments of the present disclosure.

In a case that a single test component includes a great number of test elements, it is possible to provide a plurality of test component regions for the arrangement of the great number of test elements.

As shown in FIG. 10A, the display substrate 100 includes two test component regions TGA adjacent to each other, and the test components in the two test component regions TGA are arranged side by side along the first direction D1. For example, the arrangement of the plurality of test elements in each test component region TGA may refer to the above description with reference to FIG. 7, FIG. 8 and FIG. 9, which will not be repeated here.

As shown in FIG. 10B, the display substrate 100 includes two test component regions TGA adjacent to each other, and the test components in the two test component regions TGA are arranged side by side along the second direction D1. For example, the arrangement of the plurality of test elements in each test component region TGA may refer to the above description with reference to FIG. 7, FIG. 8 and FIG. 9, which will not be repeated here.

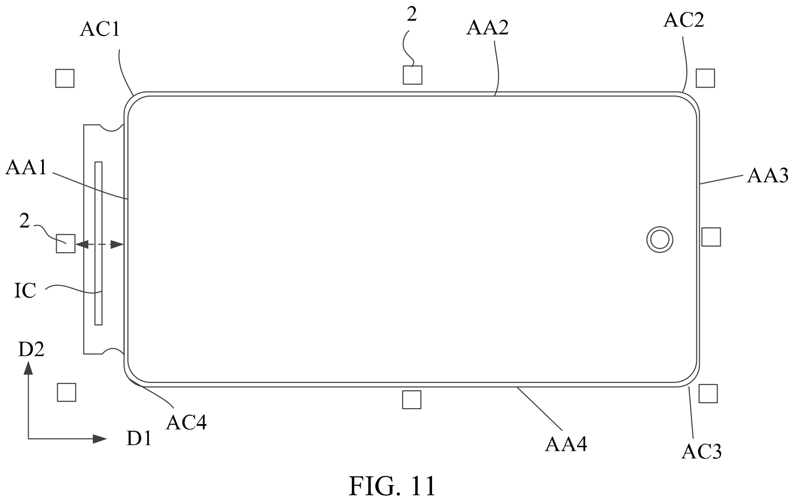

FIG. 11 shows a schematic top view of a display substrate according to yet some other exemplary embodiments of the present disclosure.

In the embodiments of the present disclosure, a plurality of test components 2 are arranged to be respectively adjacent to the first edge AA1, the second edge AA2, the third edge AA3, the fourth edge AA4, the first corner AC1, the second corner AC2, the third corner AC3 and the fourth corner AC4. For example, referring to FIG. 5 and FIG. 11, eight test components 2 are schematically shown. A test component 2 is arranged adjacent to the first edge AA1, and each of the test components 2 is arranged to be adjacent to a respective one of the first edge AA1, the second edge AA2, the third edge AA3, the fourth edge AA4, the first corner AC1, the second corner AC2, the third corner AC3 and the fourth corner AC4.

As shown in FIG. 5, the display substrate 100 includes a driver chip IC adjacent to the first edge AA1, and at least one test component 2 adjacent to the first edge AA1 is located between the driver chip IC and the first edge AA1 of the display region. The inventors have found through research that the closer the test components are to the display region, the closer the evaporation performance of the test components matches that of the film layers in the display region. In this embodiment, the test components 2 are arranged close to the display region AA, so that the pixel position accuracy in the display region may be measured more accurately.

Optionally, as shown in FIG. 11, at least one test component 2 adjacent to the first edge AA1 is arranged on a side of the driver chip IC away from the first edge AA1 of the display region AA1.

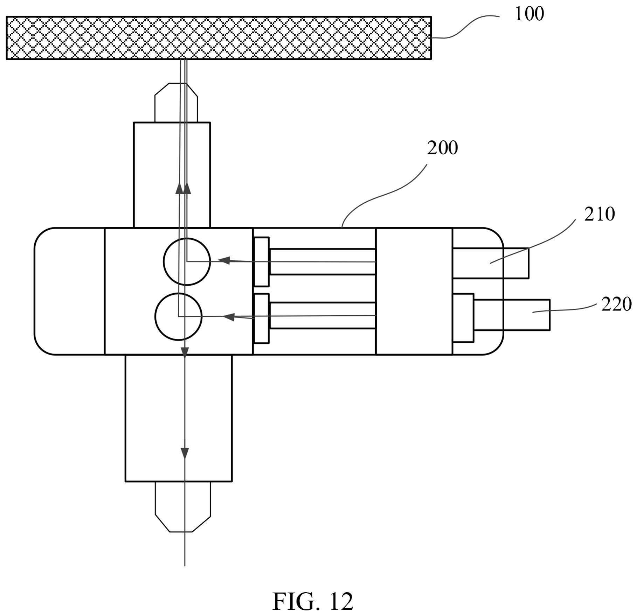

FIG. 12 shows a schematic structural diagram of a testing apparatus for measuring a pixel position accuracy of a display substrate according to some exemplary embodiments of the present disclosure.

As shown in FIG. 12, a testing apparatus 200 may include a white light source 210 and an ultraviolet light source 220. For example, a testing method may be performed in accordance with the following steps.

In step S110, the testing apparatus 200 is moved above a test component region TGA of the display substrate 100, the white light source 210 is turned on to illuminate the test component region TGA, and a first image of the test component region TGA under white light irradiation is acquired.

Specifically, during a process of moving the testing apparatus 200 above the test component region TGA, the testing apparatus 200 may be aligned with the reference mark 7 in the test component region TGA, so as to calibrate the position of the testing apparatus 200 using the reference mark 7.

In this step, a grayscale processing may be performed on the first image to obtain outlines of the test elements.

In step S120, the white light source 210 of the testing apparatus 200 is turned off.

In step S130, the test component region TGA is activated. For example, the ultraviolet light source 220 of the testing apparatus 200 is turned on so that the test elements are activated to emit light under ultraviolet light irradiation, and a second image of the test component region under the ultraviolet light irradiation is acquired, where outline patterns of the test elements may be obtained from the second image.

In step S140, a pixel position accuracy of the display substrate 100 is measured based on the first image and the second image.

Referring to FIG. 7 to FIG. 10B in combination, specifically, outlines of the first calibration mark 7, the second calibration mark 8 and the test element 3 in the image may be obtained using an image processing algorithm. For example, taking the test element 31R in FIG. 7 as an example, an imaginary line 7L for the outline of the first calibration mark 7 extending towards the test element 31R and an imaginary line 8L for the outline of the second calibration mark 8 extending towards the test element 31R are respectively obtained, and an intersection point O1 of the imaginary line 7L and the imaginary line 8L represents a theoretical center of the test element 31R. Then, two symmetry axes AX1 and AX2 of the outline of the test element 31R are obtained, and an intersection point O2 of the two symmetry axes AX1 and AX2 represents an actual center of the test element 31R. As the testing apparatus 200 is aligned with the reference mark 7, the reference mark 7 may be selected as an origin to establish a Cartesian coordinate system, and coordinate values of the intersection point O1 and the intersection point O2 may be obtained respectively. On this basis, offsets ΔX and ΔY of the intersection point O2 relative to the intersection point O1 in the horizontal and vertical coordinates may be determined, which represents an offset of the test element. The greater the offset of the test element, the lower the pixel position accuracy; and the smaller the offset of the test element, the higher the pixel position accuracy.

The embodiments of the present disclosure further provide a display device, which may include the display substrate described in any of the aforementioned embodiments. The display device may be any product or component with display function, such as a mobile phone, a tablet computer, a television, a monitor, a notebook computer, a digital photo frame, a navigator, etc.

It will be understood that the display device provided in the embodiments of the present disclosure include the above-mentioned display substrate, and the display device have the same beneficial effects as the above-mentioned display substrate, which will not be repeated here.

Although some embodiments of the general concept of the present disclosure have been shown and described, it will be understood by those skilled in the art that changes may be made to these embodiments without departing from the principles and spirit of the general concept of the present disclosure, and that the scope of the present disclosure is determined by the claims and their equivalents.

## Claims

1. A display substrate, comprising:
a base substrate, wherein the base substrate comprises a display region and a test component region;
a plurality of pixel units on the base substrate, wherein the plurality of pixel units are arranged in the display region in an array along a first direction and a second direction, and at least one pixel unit comprises a plurality of light-emitting elements stacked along a third direction, wherein the plurality of light-emitting elements stacked along the third direction comprise a charge generation layer on the base substrate, a first light-emitting layer on a side of the charge generation layer close to the base substrate, and a second light-emitting layer on a side of the charge generation layer away from the base substrate, the first direction intersects with the second direction, and the third direction is perpendicular to each of the first direction and the second direction; and
at least one test component on the base substrate, arranged in the test component region, wherein the at least one test component comprises a plurality of test elements arranged in the test component region in an array along the first direction and the second direction,
wherein the plurality of test elements comprise a first test element and a second test element, the first test element and the first light-emitting layer comprise a same material, the second test element and the second light-emitting layer comprise a same material, and the first test element and the second test element are arranged in two rows; and
wherein the display substrate further comprises a first calibration mark on the base substrate, and the first calibration mark is arranged in the test component region and between two adjacent rows of test elements.

2. The display substrate according to claim 1, wherein the first light-emitting layer comprises first light-emitting sub-layers of more than one color, the at least one test component comprises first test elements of more than one color, and the first light-emitting sub-layers of more than one color and the first test elements of more than one color comprise a same material;
wherein the second light-emitting layer comprises second light-emitting sub-layers of more than one color, the at least one test component comprises second test elements of more than one color, and the second light-emitting sub-layers of more than one color and the second test elements of more than one color comprise a same material; and
wherein the test component region has a rectangular shape and has a first size in the first direction and a second size in the second direction, the first size being smaller than the second size; and a first test element and a second test element within a same test component and having a same color are arranged in two columns arranged along the first direction, and the first test element and the second test element of the same test component and having the same color are arranged in a row extending along the first direction.

3. The display substrate according to claim 2, wherein first test elements within a same test component and having different colors are arranged in a same column extending along the second direction; and/or
wherein second test elements within a same test component and having different colors are arranged in a same column extending along the second direction.

4. The display substrate according to any one of claims 1 to 3, wherein the plurality of light-emitting elements stacked along the third direction further comprise: a first compensation layer on a side of the first light-emitting layer close to the base substrate; and a second compensation layer on a side of the second light-emitting layer close to the base substrate; and
wherein the plurality of test elements further comprise a third test element and a fourth test element, the third test element and the first compensation layer comprise a same material, the fourth test element and the second compensation layer comprise a same material, and the third test element and the fourth test element are arranged in two rows.

5. The display substrate according to claim 4, wherein the first compensation layer and the second compensation layer have a same color, and the third test element and the fourth test element are arranged in a same row extending along the first direction.

6. The display substrate according to any one of claims 2 to 5, wherein a first test element and a third test element within a same test component and having different colors are arranged in a same column extending along the second direction; and/or
wherein a second test element and a fourth test element within a same test component and having different colors are arranged in a same column extending along the second direction.

7. The display substrate according to any one of claims 1 to 6, wherein the display substrate further comprises a reference mark on the base substrate, and the reference mark is located in the test component region and between two adjacent columns of test elements in the first direction.

8. The display substrate according to claim 7, wherein the reference mark is located between two adjacent rows of test elements in the second direction.

9. The display substrate according to claim 7, wherein the display substrate further comprises a second calibration mark on the base substrate, the second calibration mark is located in the test component region and extends along the second direction, and the second calibration mark is located between two adjacent rows of test elements in the second direction.

10. The display substrate according to claim 1, wherein the at least one test component comprises q columns of test elements arranged along the first direction and n rows of test elements arranged along the second direction, q is a positive integer greater than or equal to 2, and n is a positive integer greater than or equal to 4.

11. The display substrate according to claim 10, wherein within a same test component, a first spacing, in the first direction, between two adjacent columns of test elements arranged along the first direction is greater than or equal to 150 micrometers; and/or
wherein within the same test component, the first spacing, in the first direction, between the two adjacent columns of test elements arranged along the first direction is less than or equal to 390 microns.

12. The display substrate according to claim 10 or 11, wherein the reference mark comprises a first reference mark portion extending along the first direction and a second reference mark portion extending along the second direction, and the first reference mark portion and the second reference mark portion intersect at a reference point; and
wherein a first imaginary line extends along the second direction and passes through the reference point, a second imaginary line extends along the second direction and passes through centers of at least two test elements in a column of test elements, a third imaginary line extends along the second direction and passes through centers of at least two test elements in another column of test elements, and a ratio of a first distance between the second imaginary line and the first imaginary line in the first direction to a second distance between the third imaginary line and the first imaginary line in the first direction ranges from 0.8 to 1.2.

13. The display substrate according to claim 12, wherein a fourth imaginary line extends along the first direction and passes through the reference point, a fifth imaginary line extends along the first direction and passes through centers of test elements of a row of test elements adjacent to the reference mark, a sixth imaginary line extends along the first direction and passes through centers of test elements of another row of test elements adjacent to the reference mark, and a ratio of a third distance between the fifth imaginary line and the fourth imaginary line in the second direction to a fourth distance between the sixth imaginary line and the fourth imaginary line in the second direction ranges from 0.8 to 1.2.

14. The display substrate according to any one of claims 10 to 13, wherein the display substrate comprises n first calibration marks, wherein in the first direction, an i^{th} first calibration mark is located between a first test element and a second test element of an i^{th} row of test elements, where 1 ≤ i ≤ n, and i is a positive integer.

15. The display substrate according to claim 14, wherein the display substrate comprises q second calibration marks, wherein in the second direction, one of the q second calibration marks is located between two first test elements in a first column of test elements.

16. The display substrate according to claim 14, wherein the n rows of test elements comprise a k^{th} row of test elements adjacent to the reference mark and a (k+1)^{th} row of test elements adjacent to the reference mark, the k^{th} row of test elements is spaced apart from the (k+1)^{th} row of test elements in the second direction by a second spacing, where 1≤ k ≤n-1, and k is a positive integer;
wherein a p^{th} row of test elements is spaced apart from a (p+1)^{th} row of test elements in the second direction by a third spacing, where 1≤ p ≤n-1, p is a positive integer, and p is not equal to k; and
wherein the second spacing is greater than the third spacing.

17. The display substrate according to claim 16, wherein the second spacing is at least twice the third spacing.

18. The display substrate according to any one of claims 1 to 17, wherein the display region of the display substrate comprises a first edge, a second edge, a third edge, a fourth edge, a first corner, a second corner, a third corner and a fourth corner, and each of the first corner, the second corner, the third corner and the fourth corner is located at a respective junction of two adjacent edges among the first edge, the second edge, the third edge and the fourth edge; and
wherein the display substrate comprises a plurality of test components respectively arranged adjacent to the first edge, the second edge, the third edge, the fourth edge, the first corner, the second corner, the third corner and the fourth corner.

19. The display substrate according to claim 18, wherein the display substrate comprises a driver chip adjacent to the first edge, and at least one test component adjacent to the first edge is arranged between the driver chip and the first edge of the display region.

20. The display substrate according to claim 18, wherein the display substrate comprises a driver chip adjacent to the first edge, and at least one test component adjacent to the first edge is arranged on a side of the driver chip away from the first edge of the display region.

21. The display substrate according to any one of claims 1 to 20, wherein the display substrate comprises two test component regions adjacent to each other, and test components in the two test component regions are arranged side by side along the first direction; and/or
wherein the display substrate comprises two test component regions adjacent to each other, and test components in the two test component regions are arranged side by side along the second direction.

22. A display device, comprising the display substrate according to any one of claims 1 to 21.
